# EUROPEAN PATENT SPECIFICATION

(11) **EP 3 128 661 B1**
(45) Date of publication and mention of the grant of the patent: **22.09.2021**
(21) Application number: 16182854.6
(22) Date of filing: 04.08.2016
(51) Int. Cl.: H02K 29/03, H02K 29/08, H02K 1/27, H02P 6/22, H02K 11/33, G01R 33/00, H02P 6/08, H02K 1/14

(54) **MAGNETIC SENSOR, METHOD FOR CONTROLLING AN OPERATING STATE THEREOF AND MOTOR ASSEMBLY**
MAGNETSENSOR, VERFAHREN ZUR STEUERUNG EINES BETRIEBSZUSTANDS DAVON UND MOTORANORDNUNG
CAPTEUR MAGNÉTIQUE, PROCÉDÉ POUR COMMANDER UN ÉTAT DE FONCTIONNEMENT DE CELUI-CI ET UN ENSEMBLE MOTEUR

(30) Priority: 07.08.2015 WO PCT/CN2015/086422; 01.04.2016 CN 201610203646; 02.06.2016 CN 201610387977
(43) Date of publication of application: 08.02.2017
(73) Proprietor: Johnson Electric International AG, 3280 Murten (CH)
(72) Inventor: Sun, Chi Ping, Hong Kong (HK); Xin, Fei, Hong Kong (HK); Wong, Ken, Hong Kong (HK); Yeung, Shing Hin, Hong Kong (HK); Guo, Hui Min, Hong Kong (HK); Lou, Shu Zuo, Hong Kong (HK); Chen, Xiao Ming, Hong Kong (HK); Cai, Guang Jie, Hong Kong (HK); Wong, Chun Fai, Hong Kong (HK); Huang, Shu Juan, Hong Kong (HK); Jiang, Yun Long, Hong Kong (HK); Li, Yue, Hong Kong (HK); Liu, Bao Ting, Hong Kong (HK); Wang, En Hui, Hong Kong (HK); Yang, Xiu Wen, Hong Kong (HK); Liu, Li Sheng, Hong Kong (HK); Cui, Yan Yun, Hong Kong (HK)
(74) Representative: Hocking, Adrian Niall

(56) References cited:
- US-A- 6 097 127
- US-A1- 2006 175 922
- None

## Description

### BACKGROUND

### TECHNICAL FIELD

The present teaching relates to a field of circuit technology. In particular, the present teaching relates to a magnetic sensor.

### BACKGROUND

During starting of a synchronous motor, the stator produces an alternating magnetic field causing the permanent magnetic rotor to be oscillated. The amplitude of the oscillation of the rotor increases until the rotor begins to rotate, and finally the rotor is accelerated to rotate in synchronism with the alternating magnetic field of the stator. To ensure the starting of a conventional synchronous motor, a starting point of the motor is set to be low, which results in that the motor cannot operate at a relatively high working point, thus the efficiency is low. In another aspect, the rotor cannot be ensured to rotate in a same direction every time since a stop or stationary position of the permanent magnetic rotor is not fixed. Accordingly, in applications such as a fan and water pump, the impeller driven by the rotor has straight radial vanes, which results in a low operational efficiency of the fan and water pump.

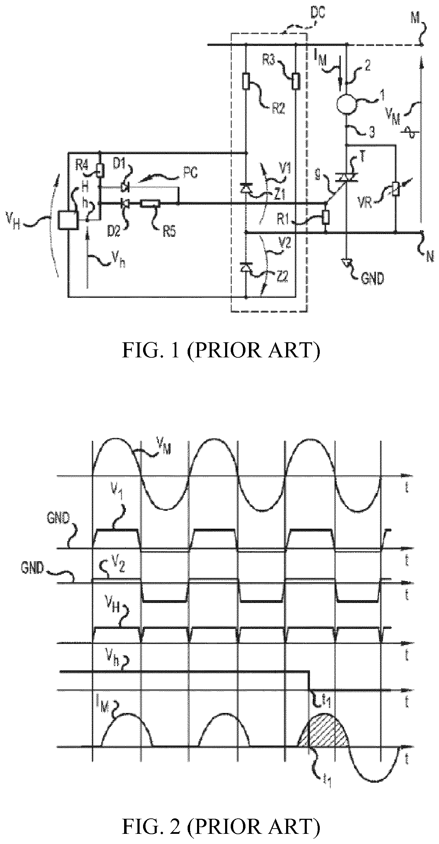

FIG. 1 illustrates a conventional drive circuit for a synchronous motor, which allows a rotor to rotate in a same predetermined direction in every time it starts. In the circuit, a stator winding 1 of the motor is connected in series with a *TRIAC* between two terminals *M* and *N* of an AC power source *VM*, and an AC power source *VM* is converted by a conversion circuit DC into a direct current voltage and the direct current is supplied to a position sensor *H.* A magnetic pole position of a rotor in the motor is detected by the position sensor *H,* and an output signal *Vh* of the position sensor *H* is connected to a switch control circuit PC to control the bidirectional thyristor *T*.

FIG. 2 illustrates a waveform of the drive circuit. It can be seen from Figure 2 that, in the drive circuit, no matter the bidirectional thyristor *T* is switched on or off, the AC power source supplies power for the conversion circuit DC so that the conversion circuit DC constantly outputs and supplies power for the position sensor *H* (referring to a signal *VH* in FIG. 2). In a low-power application, in a case that the AC power source is commercial electricity of about 200V, the electric energy consumed by two resistors *R2* and *R3* in the conversion circuit DC is more than the electric energy consumed by the motor.

The magnetic sensor applies Hall effect, in which, when current *I* runs through a substance and a magnetic field *B* is applied in a positive angle with respect to the current *I,* a potential difference *V* is generated in a direction perpendicular to the direction of current *I* and the direction of the magnetic field *B*. The magnetic sensor is often implemented to detect the magnetic polarity of an electric rotor. One arrangement for a permanent magnet DC motor is shown in US6097127.

As the circuit design and signal processing technology advances, there is a need to improve the magnetic sensor and the implemented IC for the ease of use and accurate detection.

### SUMMARY

One aspect of the present teaching provides a method for controlling an operating state of a magnetic sensor, comprising, detecting an external magnetic field, generating a magnetic induction signal, indicative of at least one characteristic associated with the detected external magnetic field, determining whether a predetermined condition is satisfied or not based on a voltage measured in the magnetic sensor, controlling, when the predetermined condition is satisfied, the magnetic sensor to operate in at least one of a first state and a second state based at least in part on the magnetic induction signal and controlling, when the predetermined condition is not satisfied, the magnetic sensor to operate in a third state. In the first state, a load current flows in a first direction from the magnetic sensor to outside of the magnetic sensor, and in the second state, a load current flows in a second direction opposite of the first direction from outside of the magnetic sensor into the magnetic sensor. The step of controlling the magnetic sensor to operate in at least one of the first and second state comprises: determining a first polarity of the external magnetic field based on the magnetic induction signal; determining a second polarity of an external AC power supply that is coupled with the magnetic sensor to provide power; controlling the magnetic sensor to operate in the first state if the first polarity is a first magnetic polarity and the second polarity is a first AC polarity; controlling the magnetic sensor to operate in the second state if the first polarity is a second magnetic polarity opposite of the first magnetic polarity and the second polarity is a second AC polarity opposite of the first AC polarity.

Another aspect of the present teaching provides a magnetic sensor, comprising a housing, an input port and an output port, both extending from the housing and an electrical circuit which comprises: a magnetic field detecting circuit, configured to detect an external magnetic field and output a magnetic induction signal that is indicative of information related to the external magnetic field; an output control circuit coupled between the magnetic field detecting circuit and the output port; a state control circuit coupled with the output control circuit and configured to determine whether a predetermined condition is satisfied and signal the same to the output control circuit, wherein when the predetermined condition is satisfied, the state control circuit is at least responsive to the magnetic induction signal to enable the output control circuit to control the magnetic sensor to operate in at least one of a first state and a second state, wherein in the first state, a load current flows in a first direction from the output port to outside of the magnetic sensor, in the second state, a load current flows in a second direction opposite of the first direction from outside of the magnetic sensor into the magnetic sensor via the output port, and when the predetermined condition is not satisfied, the state control circuit enables the output control circuit to control the magnetic sensor to operate in a third state. When the predetermined condition is satisfied, the output control circuit is configured to control the magnetic sensor to operate in the first state by allowing a load current to flow in the first direction when the magnetic induction signal indicates that the external magnetic field has a first magnetic polarity and the external AC power supply has a first polarity; and in the second state by allowing a load current to flow in the second direction when the magnetic induction signal indicates that the external magnetic field has a second magnetic polarity opposite to the first magnetic polarity and the external AC power supply has a second polarity.

Another aspect of the present teaching provides a motor assembly, comprising a motor configured to operate based on an alternating current (AC) power supply, an above described magnetic sensor, the magnetic sensor being configured to detect a magnetic field generated by the motor and to operate in an operating state determined based on the detected magnetic field and a bi-directional AC switch serially coupled with the motor and configured to control the motor based on the operating state of the magnetic sensor.

### BRIEF DESCRIPTION OF THE DRAWINGS

The methods, systems, and/or programming described herein are further described in terms of exemplary embodiments. These exemplary embodiments are described in detail with reference to the drawings. These embodiments are non-limiting exemplary embodiments, in which like reference numerals represent similar structures throughout the several views of the drawings, and wherein:
FIG. 1 illustrates a prior art drive circuit for a synchronous motor, according to an embodiment of the present teaching;
FIG. 2 illustrates a waveform of the drive circuit shown in FIG. 1;
FIG. 3 illustrates an exemplary diagram of a magnetic sensor 1105 according to an embodiment of the present teaching;
FIG. 4 illustrates an exemplary diagram of the magnetic sensor 1105 according to a different embodiment of the present teaching;
FIG. 5 illustrates an exemplary diagram of the magnetic sensor 1105 according to yet another embodiment of the present teaching;
FIG. 6 illustrates an exemplary implementation of the output control circuit 1120 according to an embodiment of the present teaching;
FIG. 7 illustrates an exemplary implementation of the output control circuit 1120 according to another embodiment of the present teaching;
FIG. 8 illustrates another exemplary diagram of the magnetic sensor 1105 according to yet another embodiment of the present teaching;
FIG. 9 illustrates an exemplary diagram of the rectifier 1150 according to an embodiment of the present teaching;
FIG. 10 illustrates an exemplary diagram of the magnetic sensor 1105 according to yet another embodiment of the present teaching;
FIG. 11 illustrates an exemplary implementation circuit of a part of the magnetic sensor 1105 according to yet another embodiment of the present teaching;
FIG. 12 illustrates another embodiment of the output control circuit 1120 in connection with the state control circuit 1140;
FIG. 13 is a flowchart of an exemplary method of signal processing performed by the magnetic sensor 1105, according to an embodiment of the present teaching;
FIG. 14 illustrates an exemplary diagram of a motor assembly 2200 incorporating the magnetic sensor discussed herein, according to an embodiment of the present teaching;
FIG. 15 illustrates an exemplary diagram of a motor 2300 according to an embodiment of the present teaching; and
FIG. 16 illustrates the waveforms of an output voltage from an AC power supply 1610 and the rectifier bridge 1150, respectively, according to an embodiment of the present teaching.

### DETAILED DESCRIPTION

In the following detailed description, numerous specific details are set forth by way of examples in order to provide a thorough understanding of the relevant teachings. However, it should be apparent to those skilled in the art that the present teachings may be practiced without such details. In other instances, well known methods, procedures, systems, components, and/or circuitry have been described at a relatively high-level, without detail, in order to avoid unnecessarily obscuring aspects of the present teachings.

Throughout the specification and claims, terms may have nuanced meanings suggested or implied in context beyond an explicitly stated meaning. Likewise, the phrase "in one embodiment/example" as used herein does not necessarily refer to the same embodiment and the phrase "in another embodiment/example" as used herein does not necessarily refer to a different embodiment. It is intended, for example, that claimed subject matter include combinations of example embodiments in whole or in part.

In general, terminology may be understood at least in part from usage in context. For example, terms, such as "and", "or", or "and/or," as used herein may include a variety of meanings that may depend at least in part upon the context in which such terms are used. Typically, "or" if used to associate a list, such as A, B or C, is intended to mean A, B, and C, here used in the inclusive sense, as well as A, B or C, here used in the exclusive sense. In addition, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

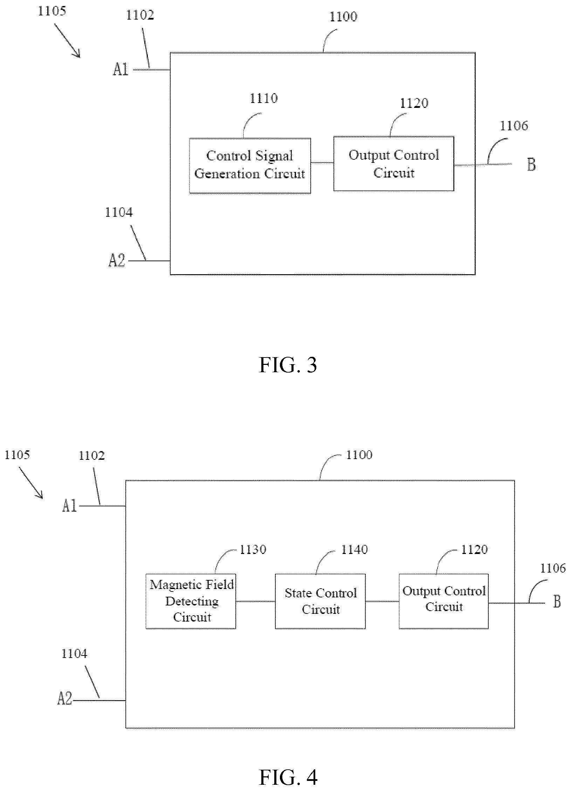

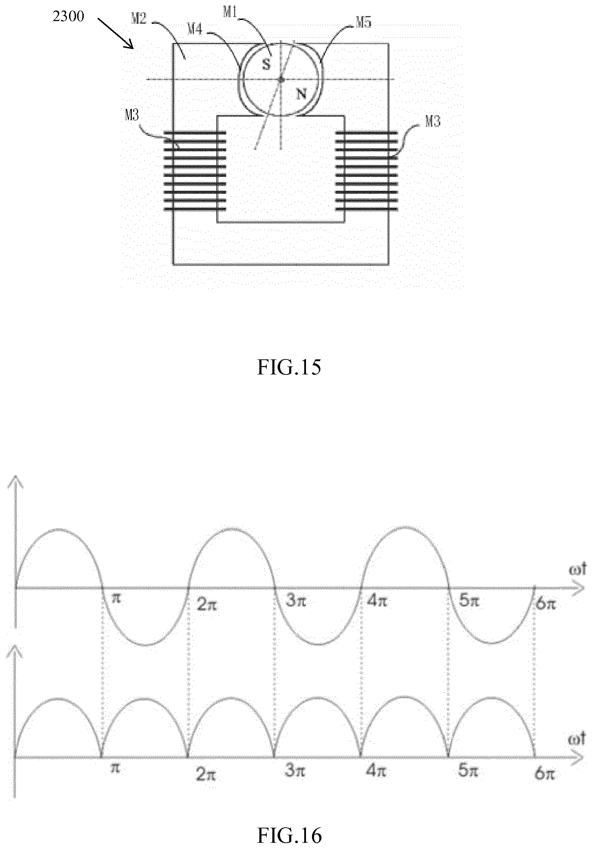

FIG. 3 illustrates an exemplary diagram of a magnetic sensor 1105 according to an embodiment of the present teaching. The magnetic sensor 1105 includes a housing (not shown), a semiconductor substrate residing in the housing (not shown), a first input A1 1102, a second input A2 1104, an output port B 1106, and an electronic circuit 1100 residing on the semiconductor substrate. The electronic circuit 1100 includes a control signal generation circuit 1110 and an output control circuit 1120 coupled to the control signal generation circuit 1110. In an embodiment, the first input A1 1102 and the second input A2 1104 may be connected to an external power supply directly (e.g., 1610 in FIG. 16). In an embodiment, the first input A1 1102 and the second input A2 1104 may be connected in series to the external power supply through, e.g., an external load.

The control signal generation circuit 1110 may be configured to detect one or more signals, and generate a control signal based on the detected one or more signals. In some examples, the one or more signals may be one or more electrical signals received through electrical wires or cables. In some other examples, the one or more signals may be one or more magnetic signals or other types of signals received by the magnetic sensor 1105 wirelessly or by other means.

In operation, the control signal generation circuit 1110 determines, based on one or more detected signals, whether a predetermined condition is satisfied. If the predetermined condition based on the one or more detected signals, the control signal generation circuit 1110 may generate and transmit a first control signal to the output control circuit 1120 that will then accordingly control the magnetic sensor 1105 to operate in a first state. In the first state, an electrical (load) current may flow out of the magnetic sensor to the output port B 1106. The control signal generation circuit 1110 may also generate and transmit a second control signal to the output control circuit 1120 to control the magnetic sensor 1105 to operate in a second state. In the second state, the electrical (load) current may flow from the output port B 1106 into the magnetic sensor. How to determine the first state or the second state at the control signal generation circuit is described in further details.

On the other hand, when it is determined that the predetermined condition is not satisfied based on the one or more detected signals, the control signal generation circuit 1110 may generate and transmit a third control signal to the output control circuit 1120 to control the magnetic sensor 1105 to operate in a third state. In the third state, no electrical (load) current flows through the output port B 1106. In some situations in the third state, only a small amount of current flows through the output port B 1106, e.g., the intensity of the current is less than one fifth of the electrical (load) current.

In some embodiment, the output control circuit 1120 is coupled with the control signal generation circuit 1110 and configured to control the magnetic sensor 1105 to operate in a state determined based on the control signal received from the control signal generation circuit 1110. For example, when the output control circuit 1120 receives the first control signal, the output control circuit 1120 controls the magnetic sensor 1105 to operate in the first state in which the electrical (load) current flows out to the output port B 1106. When the output control circuit 1120 receives the second control signal, the output control circuit 1120 controls the magnetic sensor 1105 to operate in the second state in which the electrical (load) current flows from outside into the magnetic sensor via the output port B 1106. When the output control circuit 1120 receives the third control signal, the output control circuit 1120 controls the magnetic sensor 1105 to operate in the third state in which no electrical (load) current flows through the output port B 1106 (or only a small amount of current flows through when compared with the electrical (load) current, e.g., such a current is less than one fourth of the electrical (load) current). In an embodiment, the output control circuit 1120 may alternately receive a plurality of control signals, including the first control signal and the second control signal, etc. Accordingly, the output control circuit 1120 may control the magnetic sensor 1105 to operate alternately among different states. Specifically, the magnetic sensor 1150 may operate alternately between the first state and the second state. In an embodiment, when the magnetic sensor 1105 operates in the third state, the magnetic sensor 1105 may be prevented from operating in either the first state or the second state.

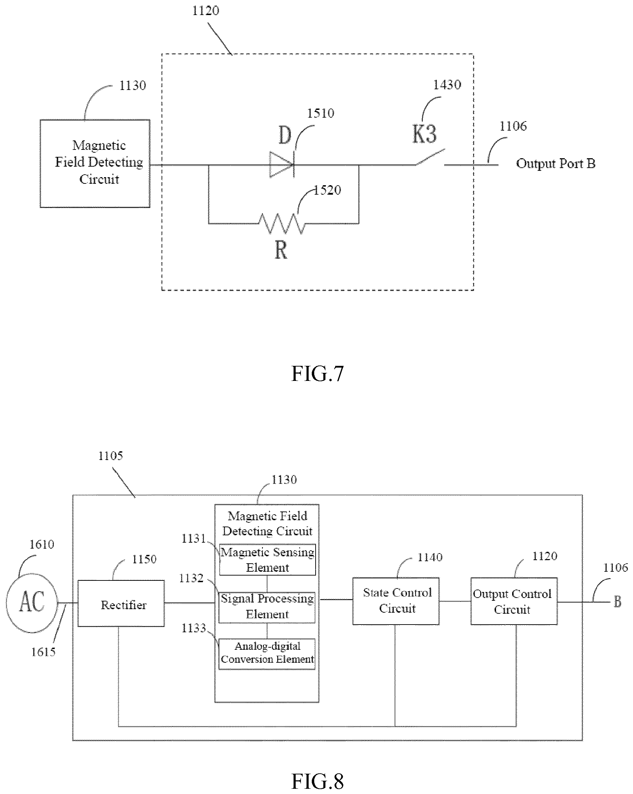

In an embodiment, when the first input A1 1102 and the second input A2 1104 are connected to the external AC power supply 1610 (FIG. 8), the operating frequency of the magnetic sensor 1105, whether in the first state, the second state, or the third state, may be set to be positively proportional to the frequency of the external AC power supply 1610. In an embodiment, the operating frequency of the magnetic sensor 1105 in the third state is twice of the operating frequency of the first state or the second state, which is twice of the frequency of the external AC power supply 1610.

FIG. 4 illustrates an exemplary diagram of the magnetic sensor 1105 according to a different embodiment of the present teaching. In this embodiment, the magnetic sensor 1105 comprises the first input A1 1102, the second input A2 1104, the output port B 1106, and an electronic circuit 1100. The electronic circuit 1100 comprises a magnetic field detecting circuit 1130, a state control circuit 1140 coupled with the magnetic field detecting circuit 1130, and the output control circuit 1120 coupled with the state control circuit 1140.

The magnetic field detecting circuit 1130 may be configured to detect an external magnetic field and output a magnetic induction signal in accordance with the detected external magnetic field. The magnetic induction signal may indicate or represent the polarity and strength of the external magnetic field.

The state control circuit 1140 may be configured to determine whether the a predetermined condition is satisfied, and transmit a corresponding control signal to the output control circuit 1120 based on the determination upon receiving the control signal, the output control circuit 1120 may control the magnetic sensor 1105 to operate in a corresponding state determined based on the magnetic induction signal. Specifically, when the predetermined condition is satisfied, the corresponding state may be one of the first state and the second state, corresponding respectively to a specific polarity of the external magnetic field indicated by the magnetic induction signal. For example, the first state may correspond to a situation in which a first polarity of the external magnetic field is detected, and the second state may correspond to a situation in which a second polarity (which is opposite to the first polarity) of the external magnetic field is detected. Accordingly, when the predetermined condition is satisfied and the external magnetic field exhibits a first polarity, the state control circuit 1140 may transmit a control signal indicating as such to the output control circuit 1120, according to which the output control circuit 1120 may control the magnetic sensor 1105 to operate in the first state. As described above, in the first state, the electrical (load) current flow from the magnetic sensor to outside via the output port B 1106. When the predetermined condition is satisfied and the external magnetic field exhibits a second polarity that is opposite to the first polarity, the state control circuit 1140 may transmit a control signal indicating as such to the output control circuit 1120, based on which the output control circuit 1120 may control the magnetic sensor 1105 to operate in the second state. As described above, in the second state, the electrical (load) current flows from outside into the magnetic sensor via the output port B 1106.

On the other hand, when the state control circuit 1140 determines that the predetermined conditions is not satisfied (or when the state control circuit 1140 does not respond to the magnetic induction signal or cannot obtain the magnetic induction signal from the magnetic field detecting circuit 1130), the state control circuit 1120 may transmit a control signal indicating as such to output control circuit 1120 to control the magnetic sensor 1105 to operate in a third state. In the third state, no electrical (load) current flows through the output port B 1106 (or only a small amount of current flows through the output port B compared with the electrical (load) current, e.g., the intensity of the current is less than one fourth of the electrical (load) current).

The output control circuit 1120 is coupled with the control signal generation circuit 1110 and configured to control the magnetic sensor 1105 to operate in a state determined based on a control signal received from the control signal generation circuit 1110. For example, when the output control circuit 1120 receives the control signal indicating that the predetermined condition is met and a first polarity of the external magnetic field, the output control circuit 1120 controls the magnetic sensor 1105 to operate in the first state, allowing the electrical (load) current flow out of the magnetic sensor via the output port B 1106. When the output control circuit 1120 receives the control signal indicating satisfaction of the predetermined condition and a second polarity detected from the external magnetic field, the output control circuit 1120 controls the magnetic sensor 1105 to operate in the second state, allowing the electrical (load) current flow from outside into the magnetic sensor via output port B 1106. When the output control circuit 1120 receives the control signal indicating that the predetermined condition is not met, the output control circuit 1120 controls the magnetic sensor 1105 to operate in the third state, in which no electrical (load) current may flow through the output port B 1106 (or only a small amount of current flows through the output port B compared with the electrical (load) current above, e.g., the current is less than one fourth of the electrical (load) current). In an embodiment, the output control circuit 1120 may receive alternately a plurality of the control signals in time. Accordingly, the output control circuit 1120 controls the magnetic sensor 1105 to operate among different states alternately, including between the first state and the second state.

In an embodiment, the output control circuit 1120 may be configured based on a user's specification. For example, the output control circuit 1120 may be configured to control the magnetic sensor 1105 to operate alternately between a working state and a high-impedance state. The working state may correspond to the first state or the second state, and the high-impedance state may correspond to the third state.

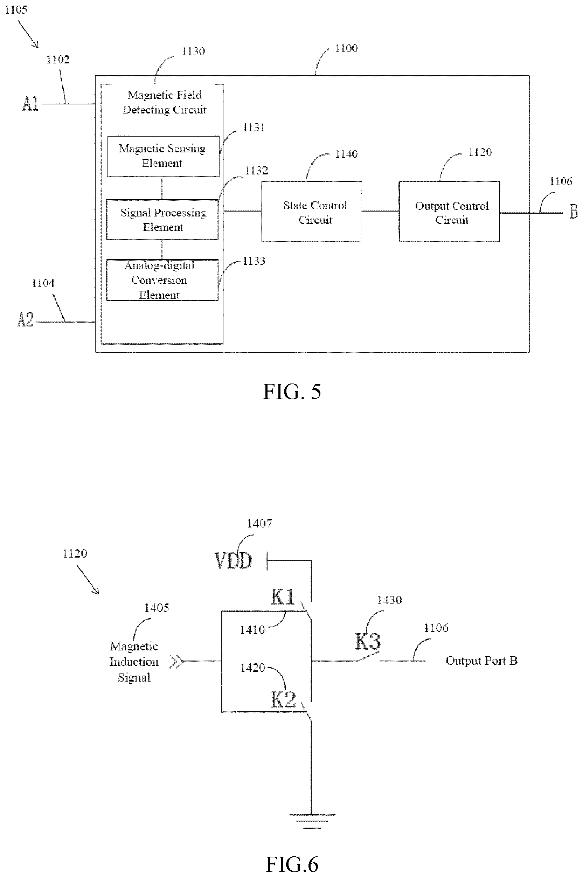

FIG. 5 illustrates an exemplary diagram of the magnetic sensor 1105 according to yet another embodiment of the present teaching. In this embodiment, an exemplary construction of the magnetic field detecting circuit 1130 is provided. The electronic circuit 1100, similar to FIG. 4, includes the magnetic field detecting circuit 1130, the state control circuit 1140, and the output control circuit 1120. The magnetic field detecting circuit 1130 in this embodiment comprises a magnetic sensing element 1131, a signal processing element 1132, and an analog-digital conversion element 1133.

The magnetic sensing element 1131 may be configured to detect and output to the signal processing element an analog electrical signal that is indicative of certain information related to the external magnetic field. For example, the output of signal from the magnetic sensing element 1131 may indicate the polarity of the external magnetic field. In an embodiment, the magnetic sensing element 1131 may be implemented based on a Hall Board.

The signal processing element 1132 may be configured to process the analog electrical signal from the magnetic sensing element 1131 and generate a processed analog electrical signal by, e.g. amplifying and reducing the interference of the analog electrical signals in order to improve the accuracy of the detected signals. The processed analog electrical signal is sent to the analog-digital conversion element 1133.

The analog-digital conversion element 1133 may be configured to convert the processed analog electrical signal to a magnetic induction signal. In situations where only the polarity of the external magnetic field needs to be detected, the magnetic induction signal may correspond to a switching digital signal. The state control circuit 1140 and the output control circuit 1120 in FIG. 5 operate in the similar manner as disclosed with respect to FIG. 4.

FIG. 6 illustrates an exemplary implementation of the output control circuit 1120 according to an embodiment of the present teaching. In an embodiment, the output control circuit 1120 may be configured according to a user's specification. As shown in FIG. 6, the output control circuit 1120 includes a first switch K1 1410, a second switch K2 1420, and a third switch K3 1430. Each of the first switch K1 1410, the second switch K2 1420, and the third switch K3 1430 is a diode or a transistor. The first switch is coupled with the output port B 1106 through the third switch K3 1430 to form a first current path allowing the load current to flow through in a first direction. The second switch is coupled with the output port B 1106 through the third switch K3 1430 to form a second current path allowing the load current to flow in a second direction opposite to the first direction. The first switch K1 1410 and the second switch K2 1420 respond to the magnetic induction signal 1405 to selectively turn on the corresponding current path.

In an embodiment, the first switch K1 1410 and the second switch K2 1420 may be selectively turned on or off according to a user's specification. In an embodiment, the first switch K1 1410 and the second switch K2 1420 may be configured to receive the magnetic induction signal 1405, which indicates the detected polarity of the external magnetic field. The first switch K1 1410 and the second switch K2 1420 may be selectively turned on or off in response to the magnetic induction signal 1405. For example, the first switch K1 1410 may be a high-voltage conducting switch, and the second switch K2 1420 may be a low-voltage conducting switch. To achieve that, the first switch K1 1410 is connected to a higher voltage VDD 1407 (e.g., a direct current power supply), and the second switch K2 1420 is connected to a lower voltage (e.g., ground). When the magnetic induction signal 1405 has a high voltage, e.g., indicating a first polarity detected from the external magnetic field, the first switch K1 1410 may be turned on and the second switch K2 1420 may be turned off. When the magnetic induction signal 1405 has a low voltage, e.g., indicating a second polarity, opposite to the first polarity of the external magnetic field, the first switch K1 1410 may be turned off and the second switch K2 1420 may be turned on.

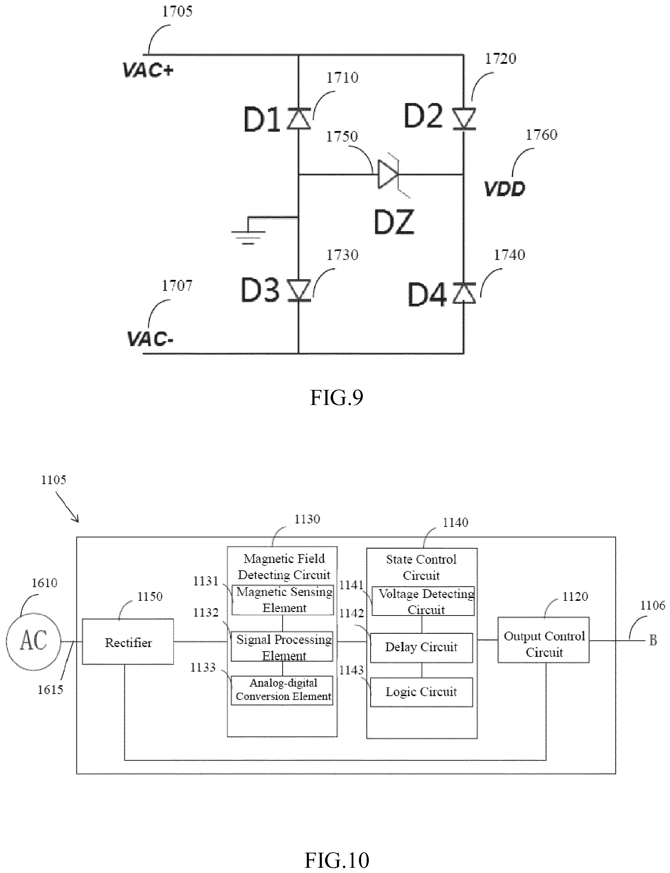

In an embodiment, the third switch K3 1430 may be turned on or off based on whether the magnetic sensor 1105 satisfies the predetermined condition. For example, when the magnetic sensor 1105 satisfies the predetermined condition, the third switch K3 1430 may be turned on. Otherwise, the third switch K3 1430 may be turned off. Details on how to control the third switch is discussed with respect to FIG. 10.

As described above, when the magnetic sensor 1105 satisfies the predetermined condition and the magnetic induction signal has a high voltage, the first switch K1 1410 is turned on, the second switch K2 1420 is turned off, and the third switch K3 1430 is turned on. Accordingly, the first current path is on and the second current path is off. As a result, the output control circuit 1120 controls the magnetic sensor 1105 to operate in the first state. Namely, the electrical (load) current flows from the VDD 1407 through the first switch K1 1410, the third switch K3 1430, and finally out of the output port B 1106.

When the magnetic sensor 1105 satisfies the predetermined condition and the magnetic induction signal has a low voltage, the first switch K1 1410 is turned off, the second switch K2 1420 is turned on, and the third switch K3 1430 is turned on. Accordingly, the first current path is off and the second current path is on. As a result, the output control circuit 1120 may control the magnetic sensor 1105 to operate in the second state. Namely, the electrical (load) current flows into the output port B 1106, through the third switch K3 1430, and the second switch K2 1420, to the ground.

When the magnetic sensor 1105 does not satisfies the predetermined condition, the third switch K3 1430 is turned off. Accordingly, neither the first current path nor the second current path is on. As a result, the output control circuit 1120 may control the magnetic sensor 1105 to operate in the third state, no matter whether the magnetic induction signal 1405 has a high voltage or a low voltage. Namely, no electrical (load) current flows through the output port B 1106 (or only a small amount of current flows through the output port B compared with the electrical (load) current above, e.g., the current is less than one fourth of the electrical (load) current and cannot drive a load outside the magnetic sensor). As such, the output control circuit 1120 does not respond to the magnetic induction signal 1405.

FIG. 7 illustrates an exemplary implementation of the output control circuit 1120 according to another embodiment of the present teaching. As shown, the output control circuit 1120 is coupled with the magnetic field detecting circuit 1130. The output control circuit 1120 receives the magnetic induction signal 1405 (as shown in FIG. 6) from the magnetic field detecting circuit 1130. The output control circuit 1120 includes a single-conducting switch D 1510, a resistance R 1520, and the third switch K3 1430. The single-conducting switch D 1510 is coupled with the output port B 1106 through the third switch K3 1340, forming a first current path allowing the load current to flow in a first direction. On the other hand, the resistance R 1520 is coupled with the output port B 1106 through the third switch K3 1430, forming a second current path allowing the load current to flow in a second direction opposite to the first direction. When the magnetic sensor 1105 satisfies the predetermined condition, the third switch K3 1430 may be turned on. Otherwise, the third switch K3 1530 may be turned off. Details on how to control the on/off of the third switch is discussed with respect to FIG. 10. The single-conducting switch D 1510 may be selectively turned on or off based on the magnetic induction signal 1405 received from the magnetic field detecting circuit 1130. For example, when the magnetic induction signal 1405 has a high voltage, the single-conducting switch D 1510 is turned on. When the magnetic induction signal 1405 has a low voltage, the single-conducting switch D 1510 is turned off. In another embodiment, the resistance R 1520 may be replaced by another single-conducting switch connected anti-parallel with the single-conducting switch D 1510.

As described above, when the magnetic sensor 1105 satisfies the predetermined condition and the magnetic induction signal 1405 received from the magnetic field detecting circuit 1130 has a high voltage, both the single-conducting switch D 1510 and the third switch K3 1430 are turned on. Accordingly, the first current path is on and the second current path is off. As a result, the output control circuit 1120 may control the magnetic sensor 1105 to operate in the first state. Namely, the electrical (load) current flows out of the output port B 1106 through the single-conducting switch D 1510 and the third switch K3 1530.

When the magnetic sensor 1105 satisfies the predetermined condition and the magnetic induction signal 1405 received from the magnetic field detecting circuit 1130 has a low voltage, the single-conducting switch D 1510 is turned off and the third switch K3 1430 is turned on. Accordingly, the first current path is off. As the magnetic induction signal is low, and the third switch K3 1430 is on, the second current path is conducting. As a result, the output control circuit 1120 may control the magnetic sensor 1105 to operate in the second state. Namely, the electrical (load) current flows into the output port B 1106, and through the third switch K3 1530 and the resistance R 1520, respectively.

When the magnetic sensor 1105 does not satisfies the predetermined condition, the third switch K3 1430 is turned off. In this case, neither the first current path nor the second current path is on. As a result, the output control circuit 1120 may control the magnetic sensor 1105 to operate in the third state no matter whether the magnetic induction signal 1405 has a high voltage or a low voltage. Namely, no electrical (load) current flows through the output port B 1106. As such, the output control circuit 1120 does not respond to the magnetic induction signal 1405.

FIG. 8 illustrates another exemplary diagram of the magnetic sensor 1105 according to yet another embodiment of the present teaching. As shown, the input 1615 of the magnetic sensor 1105 is connected to an external AC power supply 1610. In this embodiment, the magnetic sensor 1105 includes a rectifier 1150 connected to the input 1615 and configured to receive a pair of differential AC signals from the external AC power supply 1610 and convert the pair of differential AC signals to direct current (DC) signals. The output voltage of the rectifier 1150 may be used to power up the magnetic field detecting circuit 1130, the state control circuit 1140, and the output control circuit 1120. The magnetic sensor 1105 may further comprise the magnetic detecting circuit 1130, the state control circuit 1140, and the output control circuit 1120, as described above.

FIG. 9 illustrates an exemplary diagram of the rectifier 1150 according to an embodiment of the present teaching. The rectifier 1150 includes a full wave rectifier bridge and a stabilizing unit connected to the full wave rectifier. The full wave rectifier bridge includes a first diode D1 1710, a second diode D2 1720, a third diode D3 1730, and a fourth diode D4 1740. As shown in FIG. 9, the first diode D1 1710 is connected in series to the second diode D2 1720, and the third diode D3 1730 is connected in series to the fourth diode D4 1740. The output of the first diode D1 1710 and the input of the second diode D2 1720 are connected to the first input port VAC+ 1705, and the output of the third diode D3 1730 and the input of the fourth diode D4 1740 are connected to the second input port VAC- 1707. In an embodiment, the first input port VAC+ 1705 and the second input port VAC- 1707 are a pair of differential AC signals. The full wave rectifier bridge may be configured to convert the pair of differential AC signals outputted by the AC power supply 1610 to direct signals. The stabilizing unit may be a Zener diode DZ 1750 and configured to stabilize the direct signals outputted by the full wave rectifier bridge within a predetermined range. The stabilizing unit outputs a stabilized DC voltage.

In an embodiment, the input of the first diode D1 1710 is connected to the input of the third diode D3 1730 at a first connection point, thereby forming the grounded port of the full wave rectifier bridge. In addition, the output of the second diode D2 1720 is connected to the output of the fourth diode D4 1740 at a second connection point, thereby forming the output port of the full wave rectifier bridge, VDD 1760. The Zener diode DZ 1750 is situated between the first connection point and the second connection point. In an embodiment, the output VDD 1760 may be connected directly with the output control circuit 1120.

In an embodiment, the first input port VAC+ 1705 and the second input port VAC- 1707 are connected to the external AC power supply 1610. In this case, the output control circuit 1120 may respond to the polarity of the external AC power supply 1610 in addition to the magnetic induction signal 1405.

In an embodiment, whether the magnetic sensor 1105 operates in the first state, the second state, or the third state, depends on whether the magnetic sensor 1105 satisfies the predetermined condition, which may be determined according to a user's specification. Accordingly, the output control circuit 1120 may control the magnetic sensor 1105 to operate in the first state that the electrical (load) current may flow out of the output port B 1106 or in the second state that the electrical (load) current may flow into the output port B 1106. Alternatively or additionally, when the magnetic sensor 1105 satisfies the predetermined condition, the output control circuit 1120 may control the magnetic sensor 1105 to operate alternately between the first state and the second state in response to the polarity of the external AC power supply 1610 and the polarity of the magnetic field indicated by the magnetic induction signal 1405. When the magnetic sensor 1105 does not satisfy the predetermined condition, the output control circuit 1120 may control the magnetic sensor 1105 to operate in the third state that no electrical (load) current may flow through the output port B 1106 or only a small amount of current flows through the output port B compared with the electrical (load) current above, e.g., the intensity of the current is less than one fourth of the electrical (load) current.

In an embodiment, when the magnetic sensor 1105 satisfies the predetermined condition, the output control circuit 1120 may respond to both the magnetic induction signal and the external AC power supply 1610 to further control the magnetic sensor 1105 to operate in the first state or the second state. For example, when the magnetic sensor 1105 satisfies the predetermined condition and the magnetic induction signal 1405 indicates that the external magnetic field has the first magnetic polarity and the external AC power supply 1610 has the first electric polarity, the output control circuit 1120 may control the magnetic sensor 1105 to operate in the first state. For another example, when the magnetic sensor 1105 satisfy the predetermined condition and the magnetic induction signal 1405 indicates that the external magnetic field has the second magnetic polarity which is opposite to the first magnetic polarity and the AC power supply 1610 has the second electric polarity which is opposite to the first electric polarity, the output control circuit 1120 may control the magnetic sensor 1105 to operate in the second state.

FIG. 10 illustrates an exemplary diagram of the magnetic sensor 1105 according to yet another embodiment of the present teaching. In this exemplary embodiment, an exemplary construction of the state control circuit 1140 is provided. As shown, the input 1615 of the magnetic sensor 1105 is connected to an external AC power supply 1610. As shown before, the magnetic sensor 1105 includes a rectifier 1150 connected to the input 1615 and configured to receive a pair of differential AC signals from the external AC power supply 1610 and convert the pair of differential AC signals to direct current signals. The magnetic sensor 1105 further comprises the magnetic detecting circuit 1130, the state control circuit 1140, and the output control circuit 1120. As shown in FIG. 10, the state control circuit 1140 further comprises a voltage detecting circuit 1141, a delay circuit 1142, and a logic circuit 1143.

The voltage detecting circuit 1142 may be configured to detect whether a voltage in the magnetic sensor 1105 equals to or exceeds a threshold voltage. When the voltage exceeds the threshold voltage, the voltage detecting circuit 1142 generates a predetermined trigger signal and transmits it to the delay circuit 1141. In an embodiment, the voltage may be the supply voltage of the magnetic field detecting circuit 1130. The threshold voltage may be the minimal voltage required for the operation of the magnetic sensing element 1131, the signal processing element 1132, and the analog-digital conversion element 1133 of the magnetic field detecting circuit 1130. In an embodiment, the threshold voltage may set to be a value that is smaller than the stabilized DC voltage achieved by the stabilizing unit as described with respect to FIG. 9.

Once being triggered by the voltage detecting circuit 1142, the delay circuit 1141 determines whether the magnetic sensor 1105 satisfies the predetermined condition. Specifically, the delay circuit 1141 may start to time, upon the receipt of the predetermined trigger signal from the voltage detecting circuit 1142. When the timed period is equal to or longer than a predetermined length of period, the delay circuit 1141 determines that the magnetic sensor 1105 satisfies the predetermined condition. Otherwise, the delay circuit 1141 determines that the magnetic sensor 1105 does not satisfy the predetermined condition.

The logic circuit 1143 may be configured to enable the output control circuit 1120 to respond to the magnetic induction signal and control the magnetic sensor 1105 to operate in any of the three states in the manner as discussed herein. For example, the magnetic sensor will operate in the first state or the second state when the timed period recorded by the delay circuit 1141 is equal to or greater than the predetermined period. The logic circuit 1143 is further configured to enable the output control circuit 1120 to control the magnetic sensor 1105 to operate in the third state when the timed period recorded by the delay circuit 1141 is less than the predetermined period.

In an embodiment, to detect that the supply voltage of the magnetic field detecting circuit 1130 reaches the predetermined voltage threshold is to ensure that all the modules of the magnetic field detecting circuit 1130, i.e., the magnetic sensing element 1131, the signal processing element 1132, and the analog-digital conversion element 1133, may function normally.

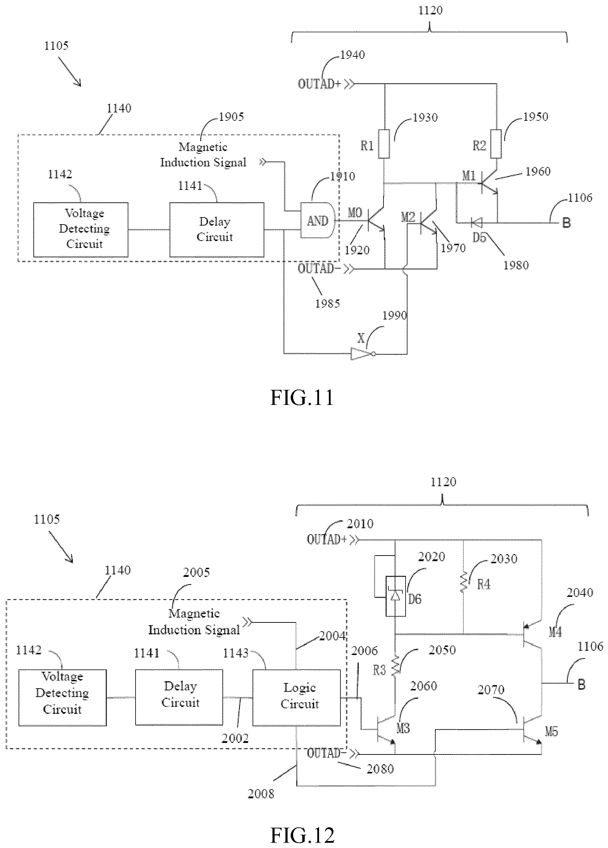

FIG. 11 illustrates an exemplary implementation circuit of a part of the the magnetic sensor 1105 according to yet another embodiment of the present teaching. Specifically, FIG. 19 illustrates an exemplary implementation of the output control circuit 1120 and the state control circuit 1140. The state control circuit 1140 includes the voltage detecting circuit 1141, the delay circuit 1142, and the logic circuit 1143, which is an AND gate 1910 as shown in FIG. 11. A first input of the AND gate 1910 may correspond to the magnetic induction signal 1905, a second input of the AND gate 1910 may be connected to an output of the delay circuit 1141, and the output of the AND gate 1910 may be connected to the output control circuit 1120.

In this embodiment, the output control circuit 1120 includes three high-voltage conducting switches M0 1920, M1 1960, M2 1970, a diode D5 1980, an inverter 1990, a first resistance R1 1930, and a second resistance R2 1950. The control terminal of the switch M0 1920 is connected to the output of the AND gate 1910. The input of the switch M0 1920 is connected to a voltage output port 1940 (OUTAD+) of the rectifier 1150 through the resistance R1 1930. The switch M2 1970 is coupled in parallel with the switch M0 1920. The control terminal of the switch M2 1970 is connected to the output of the delay circuit 1141 through the inverter 1990. In an embodiment, the equivalent resistance of the switch M2 1970 is greater than that of the switch M0 1920.

In operation, when the timed period recorded by the delay circuit 1141 is equal to or longer than the predetermined threshold period, the delay circuit 1141 outputs a high voltage. Accordingly, this high voltage allows the magnetic induction signal 1905 from the magnetic field detecting circuit 1130 is transmitted to the switch M0 1920 through the AND gate 1910. In addition, when the signal from the AC power supply 1610 is in the positive half cycle and the magnetic induction signal 1905 from the magnetic field detecting circuit 1130 outputs low voltage, the switch M0 1920 and the switch M2 1970 may be turned off, and the switch M1 1960 may be turned on. As a result, the electrical (load) current may flow out of the output port B 1106 through the switch M1 1960. Namely, the output control circuit 1120 operates the magnetic sensor 1105 in the first state. Alternatively, when the signal from the AC power supply 1610 is in the negative half cycle and the magnetic induction signal 1905 from the magnetic field detecting circuit 1130 outputs high voltage, the switch M0 1920 may be turned on, and the switches M1 1960 and M2 1970 may be turned off. As a result, the electrical (load) current may flow into the output port B 1106 and pass through the diode D5 1980 and the switch M0 1920. Namely, the output control circuit 1120 may control the magnetic sensor 1105 to operate in the second state.

When the timed period recorded by the delay circuit 1141 is shorter than the threshold period. The delay circuit 1141 and the AND gate 1910 may output a low voltage, the switches M0 1920 and M1 may be turned off, and the switch M2 1970 may be turned on. As a result, the electrical current flows into the output port B 1106 and passes through the diode D5 1980 and the switch M2 1970. Since the equivalent resistance of the switch M2 1970 is large, the electrical current is very small, or negligible. That is, the output control circuit 1120 controls the magnetic sensor 1105 to operate in the third state.

FIG. 12 illustrates another embodiment of the output control circuit 1120 in connection with the state control circuit 1140. The state control circuit 1140 includes the voltage detecting circuit 1141, the delay circuit 1142, and the logic circuit 1143. Specifically, the logic circuit 1143 of the state control circuit 1140 includes a first signal input port 2002, a second signal input port 2004, a first signal output port 2006, and a second signal output port 2008. The first signal input port 2002 may be connected to the output of the delay circuit 1141, and the second signal input port may be connected to receive the magnetic induction signal 2005. When the timed period recorded by the delay circuit 1141 is shorter than the threshold period, the logic circuit 1143 may be configured to output a low voltage as the delay circuit 1141. On the other hand, when the timed period recorded by the delay circuit 1141 is equal to or longer than the threshold period, the delay circuit 1141 may output high voltage. Further, the logic circuit 1143 may output the magnetic induction signal 2005 through the first signal output port 2006 or the second signal output port 2008. The output signals in the first signal output port 2006 and the second signal output port 2008 may have a 180 degree phase difference. It should be appreciated that the output signals in the first output port 2006 and the second output port 2008 cannot have high voltages at the same time.

In this embodiment, the output control circuit 1120 includes three switches, i.e., switches M3 2060, M4 2040, and M5 2070, two resistances, i.e., resistances R3 2050, and R4 2030, and a protecting diode D6 2020. Specifically, the switches M3 2060 and M5 2070 are both high-voltage conducting switches, and the switch M4 2040 is a low-voltage conducting switch. The control terminals of the switch M3 2060 and the switch M5 2070 are connected to the first signal output port 2006 and the second signal output port 2008 of the logic circuit 1143, respectively. The input of the switch M3 2060 is connected to a first port of the resistance R3 2050. The output of the switch M3 2060 is connected to the grounded output (OUTAD- 2080) of the rectifier 1150 (as shown in FIG. 7).

The control terminal of the switch M4 2040 is connected to a second port of the resistance R3 2050. The input of the switch M4 2040 is connected to the voltage output port (OUTAD+ 2010) of the rectifier 1150. The output of the switch M4 2040 is connected to the input of the switch M5 2070. The output of the switch M5 2070 is connected to the voltage output port (OUTAD- 2080) of the rectifier 1150. In an embodiment, the voltage output port (OUTAD- 2080) is a floating ground. The output of the switch M4 2040 is connected to the input of the switch M5 2070 and the output port B 1106. The control terminal of the switch M4 2040 is connected to the positive polarity of the protecting diode D6 2020. The input of the switch M4 2040 is connected to the negative polarity of the protecting diode D6 2020. The resistance R4 2030 is connected between the control terminal and input terminal of the switch M4 2040.

In operation, when the timed period recorded by the delay circuit 1141 is equal to or longer than the threshold period, the delay circuit 1141 outputs a high voltage. In this case, the logic circuit 1143 allows the magnetic induction signal be output through the first signal output port 2006 or the second signal output port 2008. The output signals in the first signal output port 2002 and the second signal output port 2004 may have a 180 degree phase difference. In addition, when the signal from the AC power supply 1610 is in the positive half cycle and the magnetic induction signal 2005 from the magnetic field detecting circuit 1130 corresponds to a high voltage, the switches M3 2060 and M4 2040 may be turned on, the switch M5 2070 may be turned off. As a result, the electrical (load) current flows out of the output port B 1106 through the switch M4 2040. Namely, the output control circuit 1120 controls the magnetic sensor 1105 to operate in the first state. Alternatively, when the signal from the AC power supply 1610 is in the negative half cycle and the magnetic induction signal 2005 from the magnetic field detecting circuit 1130 corresponds to a low voltage, the switches M3 2060 and M4 2040 may be turned off, and the switch M5 2070 may be turned on. As a result, the electrical current flows into the output port B 1106 and passes through the switch M5 2070. Namely, the output control circuit 1120 controls the magnetic sensor 1105 to operate in the second state.

When the timed period recorded by the delay circuit 1141 is shorter than the threshold period, the output control circuit 1120 is designated to control the magnetic sensor 1105 to operate in the third state. In this case, the delay circuit 1141 outputs a low voltage, the logic circuit 1143 outputs a low voltage at each of the first output port 2006 and the second output port 2008, and the switches M3 2060, M4 2040, and M5 2070 may be turned off. As a result, no electrical current flows through the output port B 1106 (or only a small amount of current flows through the output port B compared with the electrical (load) current above, e.g., the current is less than one fourth of the electrical (load) current).

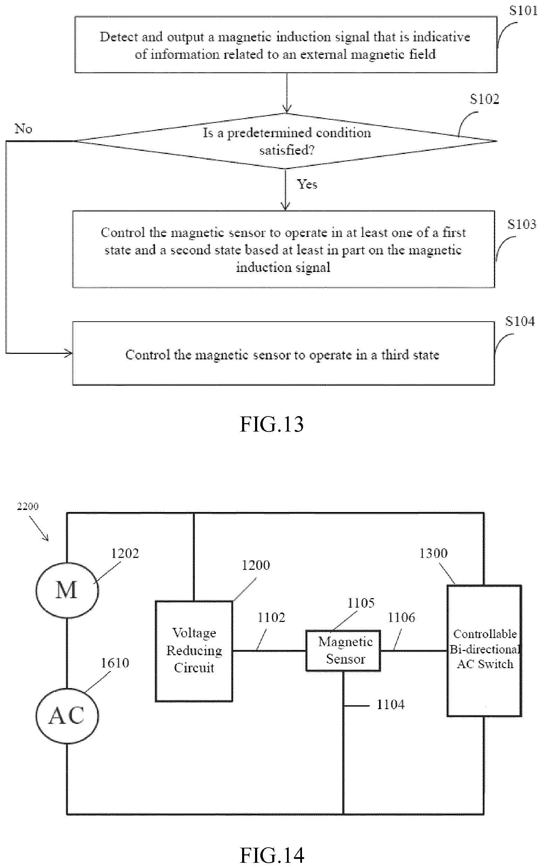

FIG. 13 is a flowchart of an exemplary method of signal processing performed by the magnetic sensor 1105, according to an embodiment of the present teaching. At step S101, an external magnetic field is detected. A magnetic induction signal may be indicative of the polarity and/or strength of the external magnetic field is generated. Specifically, at step S101, analog electrical signals associated with an external magnetic field and information associated therein are detected and outputted. In addition, the detected analog electrical signal may be processed by amplifying and reducing interference of the analog electrical signal. Further, the processed analog electrical signal may be converted to generate the magnetic induction signal. In some applications, the magnetic induction signal may be a switch digital signal that is indicative of the polarity of the external magnetic field.

At step S102, it is determined whether a predetermined condition is satisfied. The predetermined condition is related or assessed with respect to a specific voltage of the magnetic sensor. If the predetermined condition is met, the method proceeds to step S103. Otherwise, the method proceeds to step S104. Specifically, the predetermined condition may be set as a predetermined period that the voltage of the magnetic sensor reaches the predetermined voltage threshold. In an embodiment, whether the predetermined condition is satisfied may be determined based on the period of time during which the voltage of the magnetic sensor 1105 is equal to or above a predetermined voltage threshold. As discussed herein, to perform step S102, it is determined whether the voltage of the magnetic sensor 1105 reaches the predetermined voltage threshold. If so, the delay circuit 1142 starts to time. If the timed period reaches a predetermined length, it is determined that the predetermined condition is satisfied. Otherwise, it is determined that the predetermined condition is not satisfied.

At step S103, based on the magnetic induction signal, the magnetic sensor is controlled to operate in at least one of a first state and a second state. As discussed herein, in the first state, an electrical (load) current flows out of the output port B 1106. In the second state, the electrical (load) current flows into the output port B 1106. At step S104, the magnetic sensor is controlled to operate in a third state, in which the magnetic sensor 1105 operates in neither the first state nor the second state, i.e., no current (or negligible) flows through the output port B 1106.

FIG. 14 illustrates an exemplary diagram of a motor assembly 2200 incorporating the magnetic sensor discussed herein, according to an embodiment of the present teaching. The motor assembly 2200 comprises a motor M 1202 coupled with an external AC power supply 1610, a controllable bi-directional AC switch 1300 coupled in series with the motor M 1202, and the magnetic sensor 1105. The magnetic sensor 1105 resides close to the rotor of the motor 1202 in order to detect the variation of the magnetic field near the rotor.

In an embodiment, the magnetic sensor 1105 includes a first input 1102 coupled to the motor 1202, a second input 1104 coupled to the external AC power supply 1610, and the output 1106 coupled to a control terminal of the controllable bi-directional AC switch 1105.

In an embodiment, the motor assembly 2200 may further comprise a voltage reducing circuit 1105, configured to e.g., provide a reduced voltage obtained based on the AC power supply 1610, to the magnetic sensor 1105. In this embodiment, the first input 1102 of the magnetic sensor 1105 is instead coupled to the voltage reducing circuit 1200.

FIG. 15 illustrates an exemplary diagram of a motor 2300 according to an embodiment of the present teaching. The motor 2300 may be similar to the motor 1202 in FIG. 14. In an embodiment, the motor 2300 is a synchronous motor including a stator and a rotor M1 rotating around the stator. The stator includes a stator core M2 and a single phase winding M3 winding around the stator core M2. The stator core M2 may include pure iron, cast iron, cast steel, electrical steel, silicon steel, or any other soft magnetic materials. The rotor M1 includes a permanent magnet. When the stator winding M3 is coupled in series with the AC power supply 1610, the rotor M1 may operate at a uniform speed of 60f/p rpm (revolution/minute) in the stable phase, where f is the frequency of the AC power supply 1610, and p is the number of pole pairs of the rotor M1. The stator core M2 has two opposite polarities, either of which has a pole arc (e.g., M4, M5). The outer surface of the rotor M1 is opposite to the pole arc (e.g., M4, M5), thereby forming a non-uniform gap between the outer surface and the pole arc. The pole arcs (e.g., M4, M5) of the stator poles are embedded with concave grooves. The portion of the pole arc other than the concave groove has the same center axis as the rotor M1.

A non-uniform magnetic field may be formed in the above configuration, which ensures that the polar of the rotor M1 is relative to the center axis of the stator pole with an angle when the rotor M1 is static. The angle ensures an initial torque for the rotor M1 every time the motor M is powered up under the influence of the magnetic sensor 1105. The polar of the rotor M1 may be the boundary between the opposite magnetic polarities of the rotor M1. The center axis of the stator may be a line passing through the centers of the poles of the stator. In an embodiment, both the stator and the rotor M1 have two magnetic polarities. In an embodiment, the stator and the rotor M1 may have a greater number of magnetic polarities, e.g., four or six magnetic polarities.

Returning to FIG. 14, when the magnetic sensor 1105 satisfies the predetermined condition, the magnetic sensor 1105 may operate in either the first state or the second state depending on the signal from the AC power supply 1610 and the polarity of the permanent magnetic rotor M1. Specifically, when the signal from the AC power supply 1610 is in the positive half cycle and the magnetic field detecting circuit 1130 detects that the permanent magnetic rotor M1 has a first polarity, the output control circuit 1120 controls the magnetic sensor 1105 to operate in the first state. Namely, an electrical current may flow from the magnetic sensor 1105 to the controllable bi-directional AC switch 1300. Alternatively, when the signal from the AC power supply 1610 is in the negative half cycle and the magnetic field detecting circuit 1130 detects that the permanent magnetic rotor M1 has a second polarity that is opposite to the first polarity, the output control circuit 1120 controls the magnetic sensor 1105 to operate in the second state, in which, the electrical current may flow from the controllable bidirectional AC switch 1300 to the magnetic sensor 1105.

When the magnetic sensor 1105 does not satisfy the predetermined condition, the magnetic sensor 1105 operates in the third state, in which, no electrical current flows between the controllable bi-directional AC switch 1300 and the magnetic sensor 1105 (or only a small amount of current flows between the controllable bi-directional AC switch 1300 and the magnetic sensor 1105).

In an embodiment, the magnetic sensor 1105 includes the rectifier 1150 as shown in FIG. 9 and the output control circuit 1120 as shown in FIG. 6. As described above, in FIG. 6, the output control circuit 1120 includes the first switch K1 1410 which is a high-voltage conducting switch, the second switch K2 1420 which is a low-voltage conducting switch, and the third switch K3 1430. When the predetermined condition is met, the third switch K3 1430 is turned on. In addition, when the signal from the AC power supply 1610 is in the positive half cycle and the magnetic induction signal is a high voltage, the first switch K1 1410 is turned on and the second switch K2 1420 is turned off. As a result, the magnetic sensor 1105 operates in the first state, in which, the electrical current flows from the AC power supply 1610, through the motor M 1202, voltage reducing circuit 1105, the first input port of the magnetic sensor 1105, the voltage output port of the second diode D2 in the full wave rectifier bridge, the first switch K1 1410 of the output control circuit 1120, the output port B 1106, then the controllable bidirectional AC switch 1105, finally back to the AC power supply 1610. Alternatively, when the signal from the AC power supply 1610 is in the negative half cycle and the magnetic induction signal is a low voltage, the first switch K1 1410 is turned off and the second switch K2 1420 is turned on. As a result, the magnetic sensor 1105 operates in the second state, in which, the electrical current flows from the AC power supply 1610, through the controllable bi-directional AC switch 1105, the output port B 1106, the second switch K2 1420, the grounded port of the full wave rectifier bridge, the first diode D1 1710, the first input port of the magnetic sensor 1105, the voltage reducing circuit 1105, the motor 1202, and finally back to the AC power supply 1610.

When the signal from the AC power supply 1610 is in the positive half cycle and the magnetic field detecting circuit 1130 outputs a low voltage, or when the signal from the AC power supply 1610 is in the negative half cycle and the magnetic field detecting circuit 1130 outputs a high voltage, neither the first switch K1 1410 nor the second switch K2 1420 can be turned on. Therefore, the output control circuit 1120 operates the controllable bidirectional AC switch 1105 alternately between "ON" and "OFF" states in a predetermined manner. The output control circuit 1120 may further enable the magnetic sensor 1105 to control the way of powering up the stator winding M3 based on the variation of the polarity of the AC power supply 1610 and the magnetic detection information, rendering the varying magnetic field generated by the stator to rotate along with the rotor in a single direction in accordance with the position of the magnetic field of the rotor. This enables that the rotor M1 to rotate in the fixed direction every time the motor 1202 is powered up.

On the other hand, when the magnetic sensor 1105 does not satisfy the predetermined condition, the third switch K3 1430 is turned off. As a result, the magnetic sensor 1105 operates in the third state, in which, no electrical current flows in the motor assembly 2200 (or only a small negligible amount of current flows in the motor assembly 2200) compared with the electrical current above, e.g., the intensity of the current is less than one fourth of the electrical current.

FIG. 16 illustrates the waveforms of an output voltage from an AC power supply 1610 and the rectifier bridge 1150, respectively, according to an embodiment of the present teaching. Specifically, the upper portion of FIG. 16 illustrates the waveform of the output voltage from the AC power supply 1610, and the lower portion of FIG. 24 illustrates the waveform of the output voltage of the rectifier bridge 1150. As shown, the frequency of the output voltage of the rectifier bridge is twice of the frequency of the AC power supply 1610.

When the waveform of the output voltage of the rectifier bridge 1150 rises, the output control circuit 1120 may operate in the third state before the output control circuit 1120 operates in the first state or the second state. Accordingly, when the waveform of the output voltage of the AC power supply 1610 is in the positive half cycle, the magnetic sensor 1105 may operate in the first state. When the waveform of the output voltage of the AC power supply 1610 is in the negative half cycle, the magnetic sensor 1105 may operate in the second state. Therefore, the operating frequency of the third state is positively proportional to the operating frequency of the first state or the second state, and is also proportional to the frequency of voltage of the AC power supply 1610. In an embodiment, the operating frequency of the third state is twice of the operating frequency of the first state or the second state, which is twice of the frequency of the AC power supply 1610.

It should be appreciated that the examples described above are for illustrative purpose. The present teaching is not intended to be limiting. The magnetic sensor 1105 may be used in applications other than the motor assembly 2200 as described above.

Those skilled in the art will recognize that the present teachings are amenable to a variety of modifications and/or enhancements. For example, although the implementation of various components described above may be embodied in a hardware device, it can also be implemented as a software only solution - e.g., an installation on an existing server. In addition, the units of the host and the client nodes as disclosed herein can be implemented as a firmware, firmware/software combination, firmware/hardware combination, or a hardware/firmware/software combination. For another embodiment, the motor and the controllable bi-directional AC switch may be coupled in series with each other and form a first branch. The series-connected voltage reducing circuit and the magnetic sensor form a second branch. The first branch is coupled in parallel with the second branch between two ends of the external AC power supply.

While the foregoing has described what are considered to be the best mode and/or other examples, it is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings.

## Claims

1. A method for controlling an operating state of a magnetic sensor (1105), comprising:
detecting an external magnetic field;
generating a magnetic induction signal (1405, 1905, 2005), indicative of at least one characteristic associated with the detected external magnetic field;
determining whether a predetermined condition is satisfied or not based on a voltage measured in the magnetic sensor (1105);
controlling, when the predetermined condition is satisfied, the magnetic sensor (1105) to operate in at least one of a first state and a second state based at least in part on the magnetic induction signal (1405, 1905, 2005); and
controlling, when the predetermined condition is not satisfied, the magnetic sensor (1105) to operate in a third state, wherein
in the first state, a load current flows in a first direction from the magnetic sensor (1105) to outside of the magnetic sensor (1105), and
in the second state, a load current flows in a second direction opposite of the first direction from outside of the magnetic sensor (1105) into the magnetic sensor (1105),
**characterized in that** the step of controlling the magnetic sensor (1105) to operate in at least one of the first and second state comprises:
determining a first polarity of the external magnetic field based on the magnetic induction signal (1405, 1905, 2005);
determining a second polarity of an external AC power supply (1610) that is coupled with the magnetic sensor (1105) to provide power;
controlling the magnetic sensor (1105) to operate in the first state if the first polarity is a first magnetic polarity and the second polarity is a first AC polarity;
controlling the magnetic sensor (1105) to operate in the second state if the first polarity is a second magnetic polarity opposite of the first magnetic polarity and the second polarity is a second AC polarity opposite of the first AC polarity.

2. The method of claim 1, wherein the predetermined condition is satisfied when a length of time during which the voltage measure exceeds a predetermined voltage threshold exceeds a predetermined length of time.

3. The method of claim 1 or 2, wherein in the third state, there is a negligible amount of load current flowing through an output port (1106) of the magnetic sensor (1105) or no current flows through the output port (1106).

4. A magnetic sensor (1105), comprising:
a housing;
an input port (1102, 1104) and an output port (1106), both extending from the housing; and
an electrical circuit (1100) which comprises:
a magnetic field detecting circuit (1130), configured to detect an external magnetic field and output a magnetic induction signal (1405, 1905, 2005) that is indicative of information related to the external magnetic field;
an output control circuit (1120) coupled between the magnetic field detecting circuit (1130) and the output port (1106);
a state control circuit (1140) coupled with the output control circuit (1120) and configured to determine whether a predetermined condition is satisfied and signal the same to the output control circuit (1120), wherein
when the predetermined condition is satisfied, the state control circuit (1140) is at least responsive to the magnetic induction signal (1405, 1905, 2005) to enable the output control circuit (1120) to control the magnetic sensor (1105) to operate in at least one of a first state and a second state, wherein
in the first state, a load current flows in a first direction from the output port (1106) to outside of the magnetic sensor (1105),
in the second state, a load current flows in a second direction opposite of the first direction from outside of the magnetic sensor (1105) into the magnetic sensor via the output port (1106), and
when the predetermined condition is not satisfied, the state control circuit (1140) enables the output control circuit (1120) to control the magnetic sensor (1105) to operate in a third state;
**characterized in that**, when the predetermined condition is satisfied, the output control circuit (1120) is configured to control the magnetic sensor (1105) to operate
in the first state by allowing a load current to flow in the first direction when the magnetic induction signal (1405, 1905, 2005) indicates that the external magnetic field has a first magnetic polarity and the external AC power supply (1610) has a first polarity; and
in the second state by allowing a load current to flow in the second direction when the magnetic induction signal (1405, 1905, 2005) indicates that the external magnetic field has a second magnetic polarity opposite to the first magnetic polarity and the external AC power supply (1610) has a second polarity.

5. The magnetic sensor of claim 4, wherein, when the predetermined condition is satisfied, the output control circuit (1120) is further configured to control the magnetic sensor (1105) to operate alternately between the first state and the second state depending on a magnetic polarity of the external magnetic field and a polarity of an external AC power supply (1610).

6. The magnetic sensor of claim 4 or 5, wherein the output control circuit (1130) comprises
a first switch (1410) coupled with the output port (1106) to form a first current path for a load current to flow in the first direction; and
a second switch (1420) coupled with the output port (1106) to form a second current path for a load current to flow in the second direction, wherein
the first and second switches (1410, 1420) respond respectively to the magnetic induction signal (1405, 1905, 2005) to selectively turn on the first and second current paths, respectively.

7. The magnetic sensor of any one of claims 4 to 6, wherein in the third state, there is a negligible amount of load current flowing through the output port (1106) or no current flowing through the output port (1106).

8. The magnetic sensor of any one of claims 4 to 7, wherein the input port (1102, 1104) is coupled with an external alternating current power supply (1610) and the operating frequency of the magnetic sensor (1105) is positively proportional to the frequency of the external AC power supply (1610).

9. The magnetic sensor of any one of claims 4 to 7, further comprises a rectifier (1150) coupled with the input port (1102, 1104) and configured to convert the external AC power supply (1610) to a direct current (DC) power supply (1760) provided to the magnetic field detecting circuit (1130).

10. The magnetic sensor of any one of claims 4 to 9, wherein the state control circuit (1140) comprises a voltage detecting circuit (1141) configured to detect a specific voltage and, when the specific voltage equals to or is greater than a predetermined voltage threshold, output a triggering signal.

11. The magnetic sensor of claim 10, wherein the state control circuit (1140) further comprises
a delay circuit (1142) configured to time, upon receiving the triggering signal, a length of time during which the specific voltage equals to or is greater than the predetermined voltage threshold; and
a logic circuit (1143) configured to be responsive to the magnetic induction signal (1405, 1905, 2005), when the length of time exceeds a predetermined length of time, to enable the output control circuit (1120) to control the magnetic sensor (1105) to operate in at least one of the first and second state.

12. A motor assembly (2200), comprising:
a motor (1202, 2300) configured to operate based on an alternating current power supply (1610);
a magnetic sensor (1505) of any one of claims 4 to 11, the magnetic sensor (1505) being configured to detect a magnetic field generated by the motor (1202, 2300) and to operate in an operating state determined based on the detected magnetic field; and
a bi-directional AC switch (1300) serially coupled with the motor (1202, 2300) and configured to control the motor (1202, 2300) based on the operating state of the magnetic sensor (1505).

13. The motor assembly of claim 12, wherein the motor (1202, 2300) further comprises a stator, a permanent magnet rotor (M1), wherein the bi-directional AC switch (1300) is configured to control a conductive state of the stator in response to the first state and the second state, respectively, such that the stator operates in a manner consistent with a magnetic position of the permanent magnet rotor (M1) relative to the stator to drive the permanent magnet rotor (M1) in order to rotate in a pre-determined direction.

## Patentansprüche

1. Verfahren zum Steuern eines Betriebszustands eines Magnetsensors (1105), das umfasst:
Erfassen eines externen Magnetfeldes;
Erzeugen eines magnetischen Induktionssignals (1405, 1905, 2005), das mindestens ein Merkmal, das mit dem erfassten externen Magnetfeld assoziiert ist, angibt;
basierend auf einer Spannung, die in dem Magnetsensor (1105) gemessen wird, Bestimmen, ob eine vorbestimmte Bedingung erfüllt wird oder nicht,
wenn die vorbestimmte Bedingung erfüllt wird, Steuern des Magnetsensors (1105), um in mindestens einem eines ersten Zustands und eines zweiten Zustands basierend mindestens zum Teil auf dem magnetischen Induktionssignal (1405, 1905, 2005) zu arbeiten; und
wenn der vorbestimmte Zustand nicht erfüllt wird, den Magnetsensor (1105) zu steuern, um in einem dritten Zustand zu arbeiten, wobei
in dem ersten Zustand ein Laststrom in eine erste Richtung von dem Magnetsensor (1105) nach außerhalb des Magnetsensors (1105) fließt, und
in dem zweiten Zustand ein Laststrom in eine zweite Richtung, die zu der ersten Richtung entgegengesetzt ist, von außerhalb des Magnetsensors (1105) in den Magnetsensor (1105) fließt,
**dadurch gekennzeichnet, dass** der Schritt des Steuerns des Magnetsensors (1105) zum Arbeiten in mindestens einem des ersten und des zweiten Zustands umfasst:
Bestimmen einer ersten Polarität des externen Magnetfeldes basierend auf dem magnetischen Induktionssignal (1405, 1905, 2005);
Bestimmen einer zweiten Polarität einer externen Wechselstromversorgung (1610), die mit dem Magnetsensor (1105) gekoppelt ist, um Leistung bereitzustellen;
Steuern des Magnetsensors (1105), um in dem ersten Zustand zu arbeiten, falls die erste Polarität eine erste magnetische Polarität ist, und die zweite Polarität eine erste Wechselstrompolarität ist;
Steuern des Magnetsensors (1105), um in dem zweiten Zustand zu arbeiten, falls die erste Polarität eine zweite magnetische Polarität, die zu der ersten magnetischen Polarität entgegengesetzt ist, ist, und die zweite Polarität eine zweite Wechselstrompolarität, die zu der ersten Wechselstrompolarität entgegengesetzt ist, ist.

2. Verfahren nach Anspruch 1, wobei die vorbestimmte Bedingung erfüllt wird, wenn eine Zeitdauer während der die Spannungsmessung einen vorbestimmten Spannungsschwellenwert überschreitet, eine vorbestimmte Zeitdauer überschreitet.

3. Verfahren nach Anspruch 1 oder 2, wobei in dem dritten Zustand eine vernachlässigbare Laststrommenge besteht, die durch einen Ausgangsport (1106) des Magnetsensors (1105) fließt, oder kein Strom durch den Ausgangsport (1106) fließt.

4. Magnetsensor (1105), der umfasst:
ein Gehäuse,
einen Eingangsport (1102, 1104) und einen Ausgangsport (1106), die sich beide von dem Gehäuse erstrecken; und
eine Stromschaltung (1100), die umfasst:
eine Magnetfelderfassungsschaltung (1130), die dazu konfiguriert ist, ein externes Magnetfeld zu erfassen und ein magnetisches Induktionssignal (1405, 1905, 2005) auszugeben, das Informationen im Zusammenhang mit dem externen Magnetfeld angibt;
eine Ausgangssteuerschaltung (1120), die zwischen der Magnetfelderfassungsschaltung (1130) und dem Ausgangsport (1106) gekoppelt ist;
eine Zustandssteuerschaltung (1140), die mit der Ausgangssteuerschaltung (1120) gekoppelt und dazu konfiguriert ist zu bestimmen, ob eine vorbestimmte Bedingung erfüllt ist, und diese zu der Ausgangssteuerschaltung (1120) zu melden, wobei
wenn die vorbestimmte Bedingung erfüllt ist, die Zustandssteuerschaltung (1140) mindestens auf das magnetische Induktionssignal (1405, 1905, 2005) reagiert, um es der Ausgangssteuerschaltung (1120) zu ermöglichen, den Magnetsensor (1105) zu steuern, um in mindestens einem eines ersten Zustands und eines zweiten Zustands zu arbeiten, wobei
in dem ersten Zustand ein Laststrom in eine erste Richtung von dem Ausgangsport (1106) nach außerhalb des Magnetsensors (1105) fließt,
in dem zweiten Zustand ein Laststrom in eine zweite Richtung, die zu der ersten Richtung entgegengesetzt ist, von außerhalb des Magnetsensors (1105) in den Magnetsensor über den Ausgangsport (1106) fließt, und
wenn die vorbestimmte Bedingung nicht erfüllt ist, die Zustandssteuerschaltung (1140) es der Ausgangssteuerschaltung (1120) ermöglicht, den Magnetsensor (1105) zu steuern, um in einem dritten Zustand zu arbeiten;
**dadurch gekennzeichnet dass**, wenn die vorbestimmte Bedingung erfüllt ist, die Ausgangssteuerschaltung (1120) dazu konfiguriert ist, den Magnetsensor (1105) zu steuern, um zu arbeiten
in dem ersten Zustand, indem erlaubt wird, dass ein Laststrom in die erste Richtung fließt, wenn das magnetische Induktionssignal (1405, 1905, 2005) angibt, dass das externe Magnetfeld eine erste magnetische Polarität aufweist, und die externe Wechselstromversorgung (1610) eine erste Polarität aufweist; und
in dem zweiten Zustand, indem erlaubt wird, dass ein Laststrom in die zweite Richtung fließt, wenn das magnetische Induktionssignal (1405, 1905, 2005) angibt, dass das externe Magnetfeld eine zweite magnetische Polarität aufweist, die zu der ersten magnetischen Polarität entgegengesetzt ist, und die externe Wechselstromversorgung (1610) eine zweite Polarität aufweist.

5. Magnetsensor nach Anspruch 4, wobei, wenn die vorbestimmte Bedingung erfüllt ist, die Ausgangssteuerschaltung (1120) weiter dazu konfiguriert ist, den Magnetsensor (1105) zu steuern, um abwechselnd zwischen dem ersten Zustand und dem zweiten Zustand in Abhängigkeit von einer magnetischen Polarität des externen Magnetfelds und einer Polarität einer externen Wechselstromversorgung (1610) zu arbeiten.

6. Magnetsensor nach Anspruch 4 oder 5, wobei die Ausgangssteuerschaltung (1130) einen ersten Schalter (1410) umfasst, der mit dem Ausgangsport (1106) gekoppelt ist, um einen ersten Stromweg für einen Laststrom zum Fließen in die erste Richtung zu bilden; und
einen zweiten Schalter (1420), der mit dem Ausgangsport (1106) gekoppelt ist, um einen zweiten Stromweg für einen Laststrom zum Fließen in die zweite Richtung zu bilden, wobei
der erste und der zweite Schalter (1410, 1420) jeweils auf das magnetische Induktionssignal (1405, 1905, 2005) reagieren, um jeweils den ersten und den zweiten Stromweg selektiv einzuschalten.

7. Magnetsensor nach einem der Ansprüche 4 bis 6, wobei in dem dritten Zustand eine vernachlässigbare Laststrommenge besteht, die durch den Ausgangsport (1106) fließt, oder kein Strom durch den Ausgangsport (1106) fließt.

8. Magnetsensor nach einem der Ansprüche 4 bis 7, wobei der Eingangsport (1102, 1104) mit einer externen Wechselstromversorgung (1610) gekoppelt ist, und die Betriebsfrequenz des Magnetsensors (1105) zu der Frequenz der externen Wechselstromversorgung (1610) proportional ist.

9. Magnetsensor nach einem der Ansprüche 4 bis 7, der weiter einen Gleichrichter (1150) umfasst, der mit dem Eingangsport (1102, 1104) gekoppelt und dazu konfiguriert ist, die externe Wechselstromversorgung (1610) in eine Gleichstromversorgung (DC-Versorgung) (1760) umzuwandeln, die zu der Magnetfelderfassungsschaltung (1130) bereitgestellt wird.

10. Magnetsensor nach einem der Ansprüche 4 bis 9, wobei die Zustandssteuerschaltung (1140) eine Spannungserfassungsschaltung (1141) umfasst, die dazu konfiguriert ist, eine spezifische Spannung zu erfassen, und, wenn die spezifische Spannung gleich oder größer ist als ein vorbestimmter Spannungsschwellenwert, ein Ansteuersignal auszugeben.

11. Magnetsensor nach Anspruch 10, wobei die Zustandssteuerschaltung (1140) weiter umfasst
eine Verzögerungsschaltung (1142), die dazu konfiguriert ist, beim Empfangen des Ansteuersignals eine Zeitdauer zu messen, während der die spezifische Spannung gleich oder größer ist als der vorbestimmte Spannungsschwellenwert; und
eine Logikschaltung (1143), die dazu konfiguriert ist, auf das magnetische Induktionssignal (1405, 1905, 2005) zu reagieren, wenn die Zeitdauer eine vorbestimmte Zeitdauer überschreitet, um es der Ausgangssteuerschaltung (1120) zu ermöglichen, den Magnetsensor (1105) zu steuern, um in mindestens einem des ersten und des zweiten Zustands zu arbeiten.

12. Motoranordnung (2200), die umfasst:
einen Motor (1202, 2300), der dazu konfiguriert ist, basierend auf einer Wechselstromversorgung (1610) zu arbeiten;
einen Magnetsensor (1505) nach einem der Ansprüche 4 bis 11, wobei der Magnetsensor (1505) dazu konfiguriert ist, ein Magnetfeld zu erfassen, das von dem Motor (1202, 2300) erzeugt wird, und in einem Betriebszustand zu arbeiten, der basierend auf dem erfassten Magnetfeld bestimmt wird; und
einen bidirektionalen Wechselstromschalter (1300), der mit dem Motor (1202, 2300) in Reihe gekoppelt und dazu konfiguriert ist, den Motor (1202, 2300) basierend auf dem Betriebszustand des Magnetsensors (1505) zu steuern.

13. Motoranordnung nach Anspruch 12, wobei der Motor (1202, 2300) weiter einen Stator, einen Dauermagnetrotor (M1) umfasst, wobei der bidirektionale Wechselstromschalter (1300) dazu konfiguriert ist, einen leitenden Zustand des Stators als Reaktion auf jeweils den ersten Zustand und den zweiten Zustand derart zu steuern, dass der Stator auf eine Art arbeitet, die mit einer magnetischen Position des Dauermagnetrotors (M1) in Bezug zu dem Stator übereinstimmt, um den Dauermagnetrotor (M1) anzutreiben, um in einer vorbestimmten Richtung zu drehen.

## Revendications

1. Procédé pour commander un état de fonctionnement d'un capteur magnétique (1105), comprenant :
la détection d'un champ magnétique externe ;
la génération d'un signal d'induction magnétique (1405, 1905, 2005), indicatif d'au moins une caractéristique associée au champ magnétique externe détecté ;
la détermination qu'une condition prédéterminée est satisfaite ou non sur la base d'une tension mesurée dans le capteur magnétique (1105) ;
la commande, lorsque la condition prédéterminée est satisfaite, au capteur magnétique (1105) de fonctionner dans au moins l'un d'un premier état et d'un deuxième état sur la base au moins en partie du signal d'induction magnétique (1405, 1905, 2005) ; et
la commande, lorsque la condition prédéterminée n'est pas satisfaite, au capteur magnétique (1105) de fonctionner dans un troisième état, dans lequel
dans le premier état, un courant de charge circule dans une première direction depuis le capteur magnétique (1105) vers l'extérieur du capteur magnétique (1105), et
dans le deuxième état, un courant de charge circule dans une deuxième direction opposée à la première direction depuis l'extérieur du capteur magnétique (1105) jusque dans le capteur magnétique (1105),
**caractérisé en ce que** l'étape de commande au capteur magnétique (1105) de fonctionner dans au moins l'un du premier et du deuxième état comprend :
la détermination d'une première polarité du champ magnétique externe sur la base du signal d'induction magnétique (1405, 1905, 2005) ;
la détermination d'une seconde polarité d'une alimentation électrique en CA externe (1610) qui est couplée au capteur magnétique (1105) pour fournir de l'électricité ;
la commande au capteur magnétique (1105) de fonctionner dans le premier état si la première polarité est une première polarité magnétique et la seconde polarité est une première polarité de CA ;
la commande au capteur magnétique (1105) de fonctionner dans le deuxième état si la première polarité est une seconde polarité magnétique opposée à la première polarité magnétique et la seconde polarité est une seconde polarité de CA opposée à la première polarité de CA.

2. Procédé selon la revendication 1, dans lequel la condition prédéterminée est satisfaite lorsqu'une longueur de temps pendant laquelle la mesure de tension dépasse un seuil de tension prédéterminé dépasse une longueur de temps prédéterminée.

3. Procédé selon la revendication 1 ou 2, dans lequel dans le troisième état, il existe une quantité négligeable de courant de charge circulant à travers un port de sortie (1106) du capteur magnétique (1105) ou aucun courant ne circule à travers le port de sortie (1106).

4. Capteur magnétique (1105), comprenant :
un logement ;
un port d'entrée (1102, 1104,) et un port de sortie (1106), tous deux s'étendant à partir du logement ; et
un circuit électrique (1100) qui comprend :
un circuit de détection de champ magnétique (1130), conçu pour détecter un champ magnétique externe et produire un signal d'induction magnétique (1405, 1905, 2005) qui est indicatif d'informations relatives au champ magnétique externe ;
un circuit de commande de sortie (1120) couplé entre le circuit de détection de champ magnétique (1130) et le port de sortie (1106) ;
un circuit de commande d'état (1140) couplé avec le circuit de commande de sortie (1120) et conçu pour déterminer si une condition prédéterminée est satisfaite et signaler celle-ci au circuit de commande de sortie (1120), dans lequel
lorsque la condition prédéterminée est satisfaite, le circuit de commande d'état (1104) est au moins réactif au signal d'induction magnétique (1405, 1905, 2005) pour permettre au circuit de commande de sortie (1120) de commander au capteur magnétique (1105) de fonctionner dans au moins l'un d'un premier état et d'un deuxième état, dans lequel
dans le premier état, un courant de charge circule dans une première direction du port de sortie (1106) vers l'extérieur du capteur magnétique (1105),
dans le deuxième état, un courant de charge circule dans une seconde direction opposée à la première direction depuis l'extérieur du capteur magnétique (1105) jusque dans le capteur magnétique via le port de sortie (1106), et
lorsque la condition prédéterminée n'est pas satisfaite, le circuit de commande d'état (1140) permet au circuit de commande de sortie (1120) de commander au capteur magnétique (1105) de fonctionner dans un troisième état ;
**caractérisé en ce que**, lorsque la condition prédéterminée est satisfaite, le circuit de commande de sortie (1120) est conçu pour commander au capteur magnétique (1105) de fonctionner
dans le premier état en permettant à un courant de charge de circuler dans la première direction lorsque le signal d'induction magnétique (1405, 1905, 2005) indique que le champ magnétique externe présente une première polarité magnétique et que l'alimentation électrique en CA externe (1610) présente une première polarité ; et
dans le deuxième état en permettant à un courant de charge de circuler dans la seconde direction lorsque le signal d'induction magnétique (1405, 1905, 2005) indique que le champ magnétique externe présente une seconde polarité magnétique opposée à la première polarité magnétique et que l'alimentation électrique en CA externe (1610) présente une seconde polarité.

5. Capteur magnétique selon la revendication 4, dans lequel, lorsque la condition prédéterminée est satisfaite, le circuit de commande de sortie (1120) est conçu en outre pour commander au capteur magnétique (1105) de fonctionner de manière alternée entre le premier état et le deuxième état en fonction d'une polarité magnétique du champ magnétique externe et d'une polarité d'une alimentation électrique en CA externe (1610).

6. Capteur magnétique selon la revendication 4 ou 5, dans lequel le circuit de commande de sortie (1130) comprend
un premier commutateur (1410) couplé avec le port de sortie (1106) pour former un premier trajet de courant pour qu'un courant de charge circule dans la première direction ; et
un second commutateur (1420) couplé avec le port de sortie (1106) pour former un second trajet de courant pour qu'un courant de charge circule dans la seconde direction, dans lequel
les premier et second commutateurs (1410, 1420) répondent respectivement au signal d'induction magnétique (1405, 1905, 2005) pour exciter sélectivement les premier et second trajets de courant, respectivement.

7. Capteur magnétique selon l'une quelconque des revendications 4 à 6, dans lequel dans le troisième état, il existe une quantité négligeable de courant de charge circulant à travers le port de sortie (1106) ou aucun courant ne circule à travers le port de sortie (1106).

8. Capteur magnétique selon l'une quelconque des revendications 4 à 7, dans lequel le port d'entrée (1102, 1104) est couplé avec une alimentation électrique en courant alternatif externe (1610) et la fréquence de fonctionnement du capteur magnétique (1105) est positivement proportionnelle à la fréquence de l'alimentation électrique en CA externe (1610).

9. Capteur magnétique selon l'une quelconque des revendications 4 à 7, comprenant en outre un redresseur (1150) couplé avec le port d'entrée (1102, 1104) et conçu pour convertir l'alimentation électrique en CA externe (1610) en une alimentation en courant continu (CC) (1760) fournie au circuit de détection de champ magnétique (1130).

10. Capteur magnétique selon l'une quelconque des revendications 4 à 9, dans lequel le circuit de commande d'état (1140) comprend un circuit de détection de tension (1141) conçu pour détecter une tension spécifique et, lorsque la tension spécifique est supérieure ou égale à un seuil de tension prédéterminé, produire un signal de déclenchement.

11. Capteur magnétique selon la revendication 10, dans lequel le circuit de commande d'état (1140) comprend en outre
un circuit à retard (1142) conçu pour synchroniser, lors de la réception du signal de déclenchement, une longueur de temps au cours de laquelle la tension spécifique est supérieure ou égale au seuil de tension prédéterminé ; et
un circuit logique (1143) conçu pour réagir au signal d'induction magnétique (1405, 1905, 2005), lorsque la longueur de temps dépasse une longueur de temps prédéterminée, pour permettre au circuit de commande de sortie (1120) de commander au capteur magnétique (1105) de fonctionner dans au moins l'un du premier et deuxième état.

12. Ensemble moteur (2200), comprenant :
un moteur (1202, 2300) conçu pour fonctionner sur la base d'une alimentation électrique en courant alternatif (1610) ;
un capteur magnétique (1505) selon l'une quelconque des revendications 4 à 11, le capteur magnétique (1505) étant conçu pour détecter un champ magnétique généré par le moteur (1202, 2300) et pour fonctionner dans un état de fonctionnement déterminé sur la base du champ magnétique détecté ; et
un commutateur CA bidirectionnel (1300) couplé en série avec le moteur (1202, 2300) et conçu pour commander le moteur (1202, 2300) sur la base de l'état de fonctionnement du capteur magnétique (1505).

13. Ensemble moteur selon la revendication 12, dans lequel le moteur (1202, 2300) comprend en outre un stator, un rotor à aimant permanent (M1), dans lequel le commutateur CA bidirectionnel (1300) est conçu pour commander un état conducteur du stator en réponse au premier état et au deuxième état, respectivement, de telle sorte que le stator fonctionne d'une manière conforme à une position magnétique du rotor à aimant permanent (M1) par rapport au stator pour entraîner le rotor à aimant permanent (MI) afin qu'il tourne dans une direction prédéterminée.
